# EUROPEAN PATENT APPLICATION

(11) **EP 1 890 333 A2**
(43) Date of publication of application: **20.02.2008**
(21) Application number: 07015868.8
(22) Date of filing: 13.08.2007
(51) Int. Cl.: H01L 27/12

(54) **Display device and method of making the same**

(30) Priority: 18.08.2006 KR 20060078190
(71) Applicant: Samsung Electronics Co., Ltd., Yeongtong-gu Suwon-city, Gyeonggi-do 442-742 (KR)
(72) Inventor: Park, Seung-kyu, Hwaseong-si Gyeonggi-do (KR); Huh, Jong-moo, Hwaseong-si Gyeonggi-do (KR); Kim, Tae-youn, Nam-gu Ulsan (KR)
(74) Representative: Weitzel, Wolfgang

(57) **Abstract**

A display device includes an insulating substrate; a semiconductor layer formed on the insulating substrate and comprising silicon and fluorine; a source electrode of which at least a portion is formed on the semiconductor layer; a drain electrode of which at least a portion is formed on the semiconductor layer and which is separated from the source electrode with a channel region disposed therebetween; an ohmic contact layer formed between the semiconductor layer and the source electrode and between the semiconductor layer and the drain electrode; and an insulating layer formed on the semiconductor layer.

## Description

### BACKGROUND

### Field of the Invention

The present invention relates to a display device and a method of making the same and, more particularly, to a display device and a method of making the same that includes a thin film transistor having improved characteristics.

### Description of the Related Art

The flat panel display, such as the liquid crystal display (LCD) or the organic light emitting diode (OLED), have been recently used in place of the cathode ray tube (CRT).

An LCD comprises a first substrate where thin film transistors (TFTs) are formed, a second substrate disposed opposite to the first substrate, and a liquid crystal layer disposed between the two substrates. The LCD may further comprise a backlight unit located behind the first substrate. Transmittance of light from the backlight unit is controlled according to the orientation of the liquid crystal molecules in the liquid crystal layer which, in turn, is determined by the voltage applied to the pixel electrodes by the TFTs.

An OLED comprises an organic light emitting layer that emits light when provided with electrons and holes. The OLED and has the advantages of requiring a low driving voltage, light weight, slim shape, wide viewing angle, and quick response. The light-emitting intensity of the organic light emitting layer is determined by the amount of holes that are provided from a pixel electrode connected to the TFTs.

In the flat panel display comprising TFTs, display quality is significantly affected by the quality of the TFTs. However, the quality and performance of the TFTs tend to deteriorate with usage over time.

### SUMMARY

The present invention provides a display device having TFTs with improved characteristics as well' as a method of making the same. According to an embodiment of the invention, a display device comprises an insulating substrate; a semiconductor layer formed on the insulating substrate and comprising silicon and fluorine; a source electrode of which at least a portion is formed on the semiconductor layer; a drain electrode of which at least a portion is formed on the semiconductor layer and which is separated from the source electrode with a channel region disposed therebetween; an ohmic contact layer formed between the semiconductor layer and the source electrode and between the semiconductor layer and the drain electrode; and an insulating layer formed on the semiconductor layer.

According to another embodiment of the invention, the semiconductor layer is thinner in the channel region than in the circumference thereof.

According to another embodiment of the invention, the semiconductor layer comprises polysilicon.

According to another embodiment of the invention, the display device further comprises a gate electrode disposed on the insulating layer and corresponding to the channel region.

According to another embodiment of the invention, the display device further comprises a buffer layer disposed between the insulating substrate and the semiconductor layer and comprising silicon oxide.

According to another embodiment of the invention, a contact hole is formed in the insulating layer to expose the drain electrode, and the display device further comprises a pixel electrode that is connected to the drain electrode through the contact hole.

According to another embodiment of the invention, the display device further comprises an organic light emitting layer formed on the pixel electrode.

According to an embodiment of the invention, there is provided a display device comprising an insulating substrate; a semiconductor layer formed on the insulating substrate and comprising silicon; a source electrode of which at least a portion is formed on the semiconductor layer; a drain electrode of which at least a portion is formed on the semiconductor layer and which is separated from the source electrode with a channel region disposed therebetween; an ohmic contact layer formed between the semiconductor layer and the source electrode, and between the semiconductor layer and the drain electrode; an interface layer formed on the semiconductor layer in the channel region and comprising silicon and fluorine; and an insulating layer formed on the interface layer.

According to an embodiment of the invention, there is provided a display device comprising forming a semiconductor layer and an ohmic contact layer sequentially on an insulating substrate; forming a source electrode and a drain electrode which are separated from each other with a channel region disposed therebetween on the ohmic contact layer; exposing the semiconductor layer disposed between the source electrode and the drain electrode by removing a portion of the ohmic contact layer which is not covered with the source electrode and the drain electrode; acid-treating the exposed semiconductor layer; and forming an insulating layer on the semiconductor layer after the acid-treating.

According to another embodiment of the invention, the acid-treating is performed with at least one of hydrofluoric acid, sulphuric acid, and nitric acid.

According to another embodiment of the invention, the acid-treating is performed with hydrofluoric acid.

According to another embodiment of the invention, the concentration of the hydrofluoric acid is 0.001 volume percent to 10 volume percent.

According to another embodiment of the invention, the acid-treating is performed with a dipping method or a spray method.

According to another embodiment of the invention, the method further comprises treating the semiconductor layer with hydrogen plasma after the acid-treating.

According to another embodiment of the invention, the forming the semiconductor layer comprises forming an amorphous silicon layer on the insulating substrate and crystallizing the amorphous silicon layer.

According to another embodiment of the invention, the method further comprises forming a buffer layer including silicon oxide on the insulating substrate, wherein the amorphous silicon layer is formed on the buffer layer.

According to another embodiment of the invention, the method further comprises forming a gate electrode on the insulating layer corresponding to the channel region.

According to another embodiment of the invention, the method further comprises forming a contact hole in the insulating layer to expose the drain electrode; and forming a pixel electrode which is connected to the drain electrode through the contact hole.

According to another embodiment of the invention, the method further comprises forming an organic light emitting layer on the pixel electrode.

Additional features of the invention will be set forth in the description which follows, and in part will be apparent from the description, or may be learned by practice of the invention.

The scope of the invention is defined by the claims, which are incorporated into this section by reference. A more complete understanding of embodiments of the present invention will be afforded to those skilled in the art, as well as a realization of additional advantages thereof, by a consideration of the following detailed description of one or more embodiments. Reference will be made to the appended sheets of drawings that will first be described briefly.

### BRIEF DESCRIPTION OF THE DRAWINGS

A further understanding of the invention imay be obtained from a reading of the ensuing description together with the drawing, in which:
FIG. 1 is an equivalent circuit diagram of a pixel in a display device according to a first embodiment of the present invention.
FIG. 2 is a sectional view of the display device according to the first embodiment of the present invention.
FIGs. 3A to 3H illustrate a method of manufacturing the display device according to the first embodiment of the present invention.
FIG. 4 illustrates a concentration of fluorine taken along line A-A in FIG. 2.
FIG. 5 illustrates variations on characteristics of a TFT according to an acid treatment.
FIG. 6 illustrates variations on characteristics of the TFT according to an acid treatment and a hydrogen plasma treatment.
FIGs. 7A to 7B illustrate variations on characteristics of the TFT according to a degree of the acid treatment.
FIGs. 8 to 10 are sectional views of a display device according to a second to a fourth embodiments of the present invention.

Embodiments of the present invention are best understood by referring to the detailed description that follows. It should be appreciated that like reference numerals are used to identify like elements illustrated in one or more of the figures. It should also be appreciated that the figures may not be necessarily drawn to scale.

### DETAILED DESCRIPTION

In the following description, if a layer is said to be formed 'on' another layer, then a third layer may be disposed between the two layers or the two layers may be in contact with each other. In other words, it will be understood that when an element such as a layer, film, region, or substrate is referred to as being "on" another element, it can be directly on the other element or intervening elements may also be present. Further, a layer is said to be formed 'right on' another layer, it will be understood that the two layers are in contact with each other.

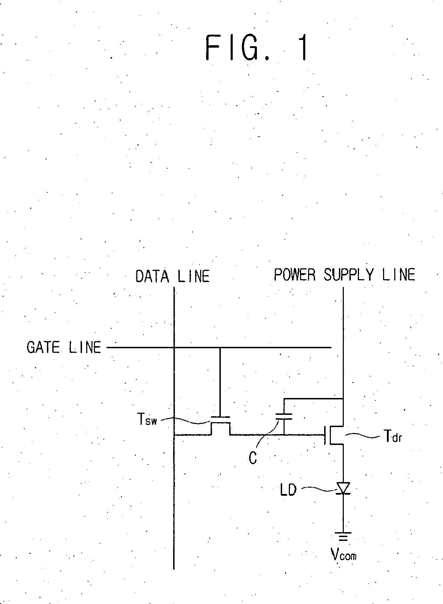

FIG. 1 is an equivalent circuit diagram of a pixel in a display device according to a first embodiment of the present invention.

One pixel comprises a plurality of signal lines. The signal lines comprise a gate line to transmit a scanning signal, a data line to transmit a data signal and a power supply line to transmit a driving voltage. The data line and the power supply line are disposed adjacently and parallel to each other. The gate line extends perpendicularly to the data line and the power supply line.

Each pixel comprises an organic light emitting element LD, a switching thin film transistor Tsw, a driving thin film transistor Tdr and a capacitor C.

The driving thin film transistor Tdr comprises a control terminal, an input terminal, and an output terminal. The control terminal is connected to the switching thin film transistor Tsw, the input terminal is connected to the power supply line, and the output terminal is connected to the organic light emitting element LD.

The organic light emitting element LD comprises an anode connected to the output terminal of the driving thin film transistor Tdr and a cathode connected.to a common voltage Vcom. The organic light emitting element LD emits light with variable intensity to display an image according to the output current from the driving thin film transistor Tdr. The intensity of the current from the driving thin film transistor Tdr varies depending on the voltage between the control terminal and the output terminal.

The switching thin film transistor Tsw comprises a control terminal, an input terminal, and an output terminal. The control terminal is connected to the gate line, the input terminal is connected to the data line, and the output terminal is connected to the control terminal of the driving thin film transistor Tdr. The switching thin film transistor Tsw transmits the data signal applied to the data line to the driving thin film transistor Tdr according to the scanning signal applied to the gate line.

The capacitor C is connected between the control terminal of the driving thin film transistor Tdr and the input terminal thereof. The capacitor C is charged with the data signal input to the control terminal of the driving thin film transistor Tdr and maintains it.

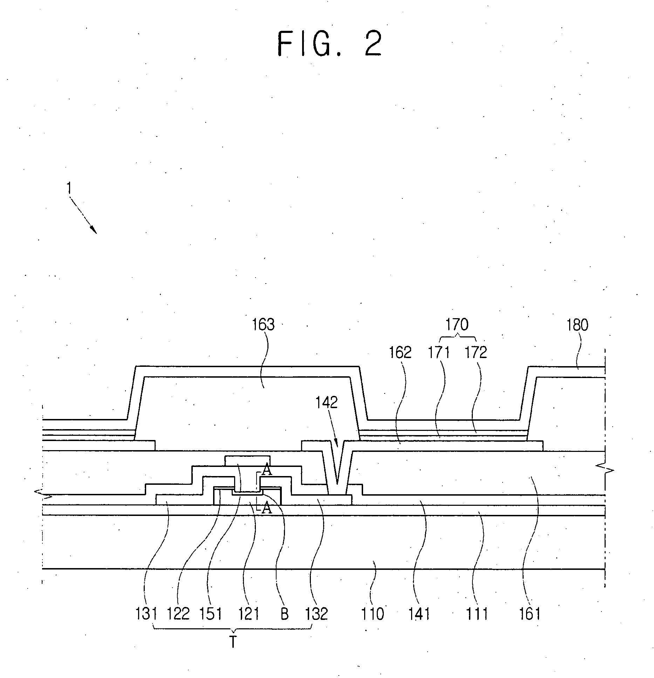

Hereinafter, a display device 1 according to the first embodiment of the present invention will be described with reference to FIG. 2. FIG. 2 shows only the driving thin film transistor Tdr without the switching thin film transistor Tsw. A buffer layer 111 is formed on an insulating substrate 110 which is made of glass, quartz, ceramic, plastic, or the like. The buffer layer 111 may be made of silicon oxide (SiOx) and prevents impurities in the insulating substrate 110 from infiltrating into a semiconductor layer 121 in the process of crystallizing the semiconductor layer 121. Semiconductor layer 121 includes polysilicon and is formed on the buffer layer 111.

An ohmic contact layer 122 is formed on semiconductor layer 121 and divided into two parts thereon. The portion of semiconductor layer 121 which is exposed between the two parts of ohmic contact layer 122 forms a channel region. Interface B on semiconductor layer 121 in the channel region includes fluorine. A portion of semiconductor layer 121 in the channel region is thinner than the other portion thereof under the ohmic contact layer 122. Ohmic contact layer 122 is made of n+ polysilicon which is highly doped with n-type impurities.

A source electrode 131 and a drain electrode 132 are formed on the two parts of the ohmic contact layer 122 respectively. The source electrode 131 and the drain electrode 132 are formed at the same time and may include a metal single layer or metal multi layers.

A first insulating layer 141 is formed on the source electrode 131, the drain electrode 132, and the semiconductor layer 121. The first insulating layer 141 may be made of silicon nitride (SiNx).

A gate electrode 151 is formed on the first insulating layer 141 to correspond to the channel region. The gate electrode 151 may include a metal single layer or metal multi layers.

A second insulating layer 161 is formed on the gate electrode 151 and the first insulating layer 141. The second insulating is provided as a flattening layer and may be made of an organic material. The organic material may use one of benzocyclobutene (BCB), olefin, acrylic resin, polyimde, and fluoroplastic.

A pixel electrode 162 of a transparent electrode is formed on the second insulating layer 161. The pixel electrode includes a transparent conductive material such as indium tin oxide (ITO), indium zinc oxide or the like. A contact hole 142 is formed in the first insulating layer 141 and the second insulating layer 161 to expose the drain electrode 132. The pixel electrode 162 is electrically connected to the drain electrode 132 through the contact hole 142. The pixel electrode 162 is referred to as an anode and provides holes to an organic layer 170.

A wall 163 is formed between neighboring pixel electrodes 162. The wall 163 divides the pixel electrodes 162 to define a pixel region. The wall 163 may include a photoresist material with thermal resistance and solvent resistance, such as acrylic resin, polyimide resin, etc., or an inorganic material, such as SiO₂, TiO₂, etc. The wall 171 may have a double-layered structure of an organic layer and an inorganic layer.

The organic layer 170 is formed on a portion of the pixel electrode 162 which is not covered with the wall 163. The organic layer 170 comprises a hole injecting layer 171 and a light emitting layer 172.

The hole injecting layer 171 may include a hole injecting material such as poly-3,4-ethylenedioxythiophene (PEDOT), poly styrenesulfonate acid (PSS) or the like and be formed by ink-jetting the hole injecting material in an aqueous suspension state.

The light emitting layer 172 may include Polyfluorene derivatives, Poly(para-phenylene vinylene) derivatives, Polyphenylene derivatives, Poly(vinylcarbazole) derivatives and Poly thiophene derivatives; or compounds thereof doped with a Perillene group pigment, Rhodermine, Rubrene, Perillene, 9,10-diphenylanthracene, Tetraphenylbutadien, Nile red, Cumarine 6, Quinacridone, or the like.

A common electrode 180 is formed on the wall 163 and the light emitting layer 172. The common electrode 180 is referred to as a cathode and provides electrons to the light emitting layer 172. The common electrode 180 may include a calcium layer and an aluminum layer which are layered.

Holes provided from the pixel electrode 162 and electrons provided from the common electrode 180 are combined into excitons in the light emitting layer 172, and then the excitons generate light while being inactivated.

The display device 1 may further comprise a passivation layer (not shown) to protect the common electrode 180 and an encapsulation member (not shown) to prevent moisture and air from infiltrating into the organic layer 170. The encapsulation member may comprise an encapsulation resin and an encapsulation can.

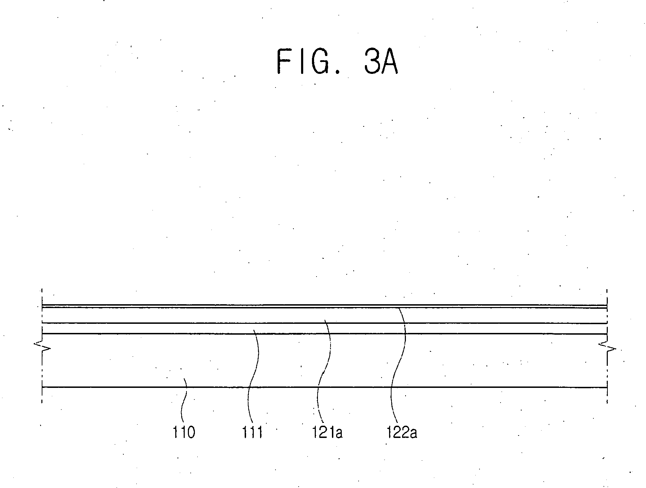

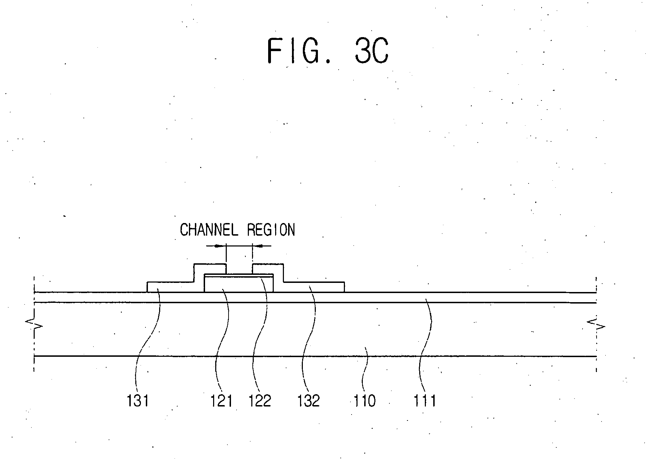

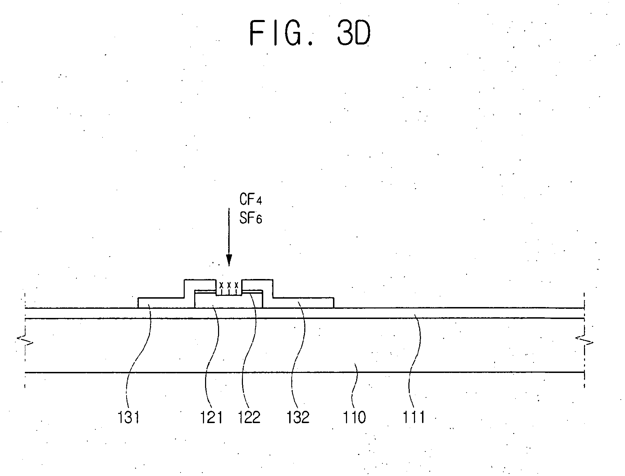

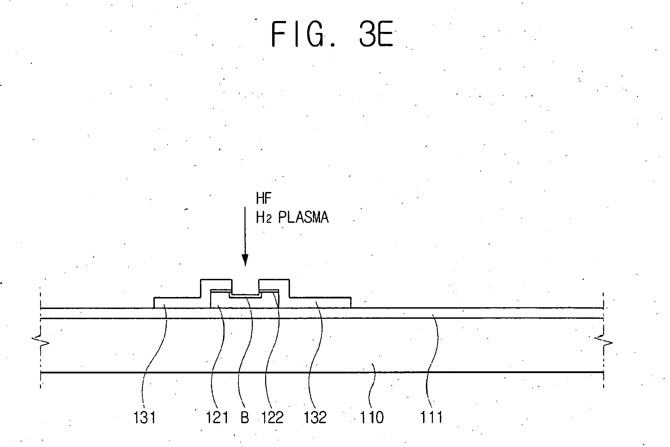

A method of making the display device 1 according to the first embodiment will be described with reference to FIGs. 3A through 3H.

Referring to FIG. 3A, the buffer layer 111, a semiconductor of amorphous silicon 121a and a ohmic contact layer 122a of amorphous silicon are sequentially formed on the insulating substrate 110. The semiconductor layer 121a of amorphous silicon and the ohmic contact layer 122a of amorphous silicon are formed throughout the buffer layer 111.

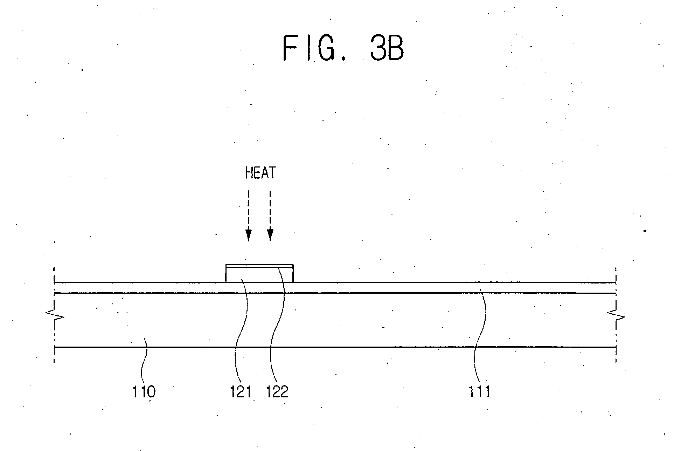

Referring to FIG. 3B, the semiconductor layer 121a of amorphous silicon and the ohmic contact layer 122a of amorphous silicon are patterned and crystallized by heat to form the semiconductor layer 121 and the ohmic contact layer 122 which are made of polysilicon. Amorphous silicon in the semiconductor layer 121a and the ohmic contact layer 122a are changed into polysilicon through crystallization.

The crystallization process may be solid phase crystallization (SPC), laser crystallization, rapid thermal annealing (RTA), etc.

Solid phase crystallization is a process to obtain a largesize crystallized silicon grains by annealing at temperature lower than 600°C for long time. Laser crystallization is a process to obtain crystallized silicon using, e.g. excimer laser annealing and sequential lateral solidification. Rapid thermal annealing is a process to obtain crystallized silicon by rapidly irradiating the surface of the amorphous silicon with light at low temperature.

Alternatively, semiconductor layer 121a of amorphous silicon and ohmic contact layer 122a of amorphous silicon may be crystallized and then patterned.

Referring to FIG. 3C, a first metal layer (not shown) is deposited and patterned to form source electrode 131 and drain electrode 132. The source 131 and the drain electrode 132 are separated from each other with the channel region disposed therebetween. Ohmic contact layer 122 is exposed in the channel region.

Referring to FIG. 3D, ohmic contact layer 122 in the channel region is etched so as to be divided into two parts, thereby exposing a portion of the semiconductor layer 121 between the two parts of the ohmic contact layer 122. The semiconductor layer 121 is partially etched, and thus a portion of the semiconductor layer 121 in the channel region becomes thinner than the portion thereof under the ohmic contact layer 122.

Ohmic contact layer 122 is etched with plasma, and the surface of semiconductor layer 121 in the channel region below may be affected and be damaged by the plasma. That is, the silicon-silicon bond and the silicon-hydrogen bonds are broken, thereby generating an unstable silicon atom having a non-bonding site. Further, the annealed silicon may turn back to an amorphous state. The unstable silicon atom may combine with impurities such as contamination elements and remain unstable, thereby degrading the performance, stability, and reliability of the TFT.

Ohmic contact layer 122 may be etched with CF4 and SF6. In this process, since the speed of etching the semiconductor layer 121 is faster than the speed of introducing a fluorine atom into the semiconductor layer 121, the fluorine atom is not introduced into the semiconductor layer 121.

In the TFT T, when a voltage is applied to the gate electrode 151, a normal current path is formed in the semiconductor layer 121. However, if there is unstable silicon, the current is trapped by the unstable silicon, and thus, thenormal Iₒₙ/I_{off} characteristic cannot be accomplished, and leakage current increases.

FIG. 3E shows that the exposed portion of the semiconductor layer 121 is treated with acid to remove the unstable silicon atom.

Acid treatment is performed by dipping the exposed semiconductor layer 121 in hydrofluoric acid. The concentration of the hydrofluoric acid may be between 0.001 volume percent to 10 volume percent, and the treatment may take tens of seconds to tens of minutes. If the concentration of the hydrofluoric.acid is less than 0.0001 volume percent, the treatment takes excessively lots of time. If the concentration of the hydrofluoric acid is more than 10 volume percent, the insulating substrate 110 may be damaged.

The acid treatment may be performed at normal or higher pressure and temperature in order to improve efficiency.

Through the acid treatment, the surface of the exposed semiconductor layer 121 is polished, and the unstable or amorphous silicon atom is etched to be removed from the surface.

The etching speed of the acid treatment may be about 40Å per minute, and accordingly the semiconductor layer 121 becomes slightly thinner. In the acid treatment, the semiconductor layer 121 is doped with fluorine from the hydrofluoric acid and thus interface B, that includes fluorine is formed thereon. A portion of the ohmic contact layer 122 which is adjacent to the channel region may also be doped with fluorine.

Alternatively, the semiconductor layer 121 in the channel region may be polished with nitric acid or sulphuric acid using a spray method instead of a dipping method.

Then, the semiconductor layer 121 is treated with hydrogen plasma, thereby improving the bonding of semiconductor layer 121 with first insulating layer 141.

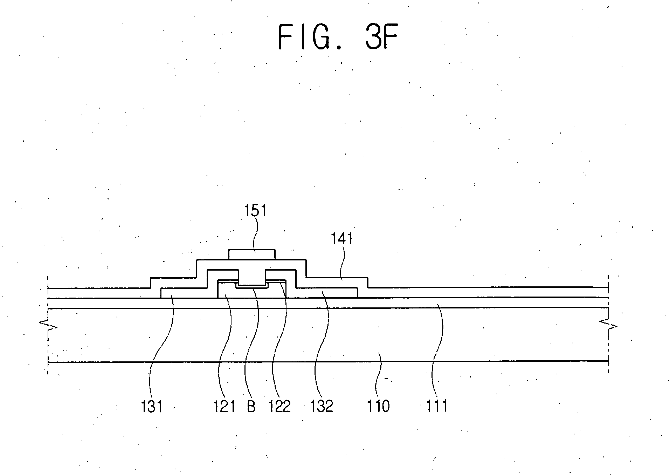

Referring to FIG. 3F, the first insulating substrate 141 and the gate electrode 151 are formed. A silicon nitride material is deposited by a chemical vapor deposition (CVD) to form the first insulating layer 141. A second metal layer (not shown) is deposited and patterned to form the gate electrode 151 corresponding to the channel region.

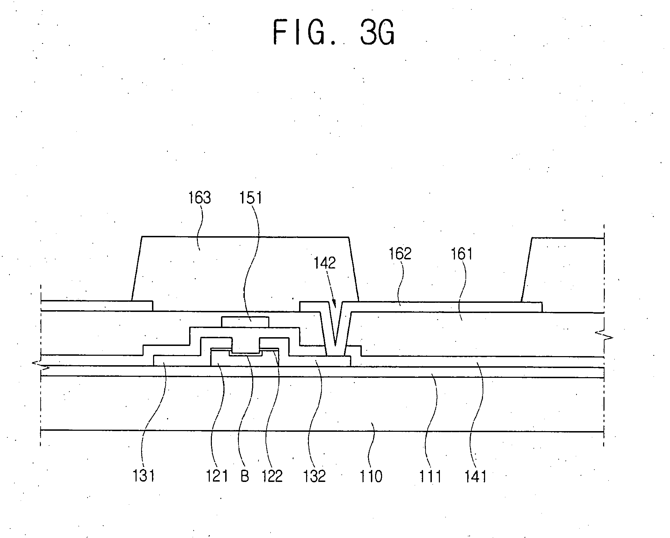

Referring to FIG. 3G, the second insulating layer 161, the pixel electrode 162, and the wall 163 are formed. The second insulating layer 161 includes an organic material and may be formed by spin coating, slit coating, screen printing, etc. The contact hole 142 is formed to expose the drain electrode 132 when the second insulating layer 162 is formed.

An ITO or IZO layer is deposited and photolithographed to form the pixel electrode 162. Then, a wall material layer is coated throughout on the pixel electrode 162 and the second insulating layer 162, and is exposed to form the wall 163. The wall material layer includes a photoresist material, and the wall 163 is formed by slit coating, spin coating, or the like.

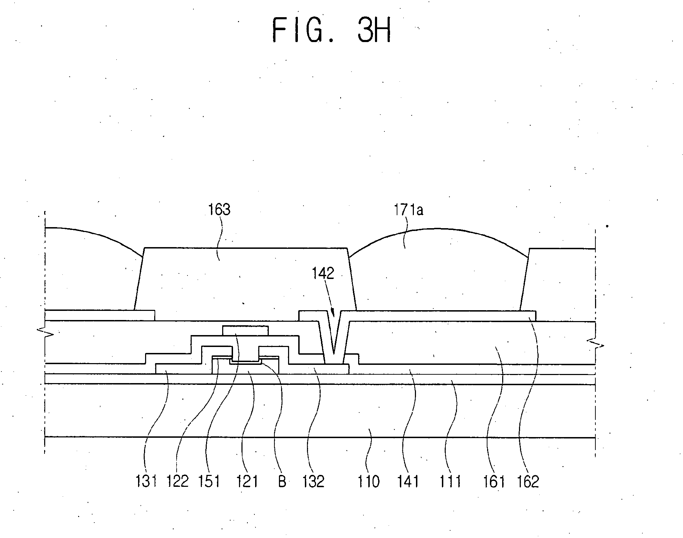

Referring to FIG. 3H, a hole injecting solution 171a, a polymer solution including a hole injecting material, is dropped by ink jetting on the pixel electrode 162 to form the hole injecting layer 171. The hole injecting solution 171a is dried to form the hole injecting layer 171. Then, the light emitting layer 172 is formed by the same process as the hole injecting layer 171, and the common electrode 180 is formed throughout thereon, thereby completing the display device 1 illustrated in FIG. 2.

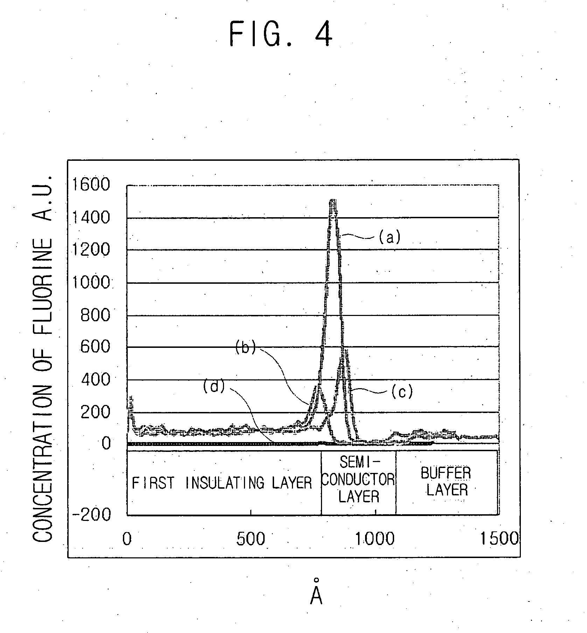

In the display device 1 according to the first embodiment, the characteristics of the TFT are improved by the acid treatment, which will be explained with reference to FIGs. 4 to 7B.

FIG. 4 sequentially illustrates the concentration of the fluorine taken along line A-A in FIG. 2, in the first insulating layer 141, the semiconductor layer 121, and the buffer layer 111. Line (a) shows the concentration of the fluorine under the acid treatment with hydrofluoric acid for 120 seconds; line (b) shows one under the acid treatment with hydrofluoric acid for 60 seconds; line (c) shows one under the acid treatment with hydrofluoric acid for 60 seconds, and then washing with oxygen plasma; and line (d) shows one under the washing with oxygen plasma without the acid treatment with hydrofluoric acid.

The concentration of the fluorine is measured by a secondary ion mass spectrometry (SIMS).

In FIG. 4, fluorine is not substantially detected in case (d) using only deionized water. On the other hand, fluorine is detected on the semiconductor layer 121, and the concentration thereof increases according to the increase of processing time in cases (a), (b) and (c). Fluorine is also detected on a lower portion of the first insulating layer 141 because of permeation of fluorine into the semiconductor layer 121.

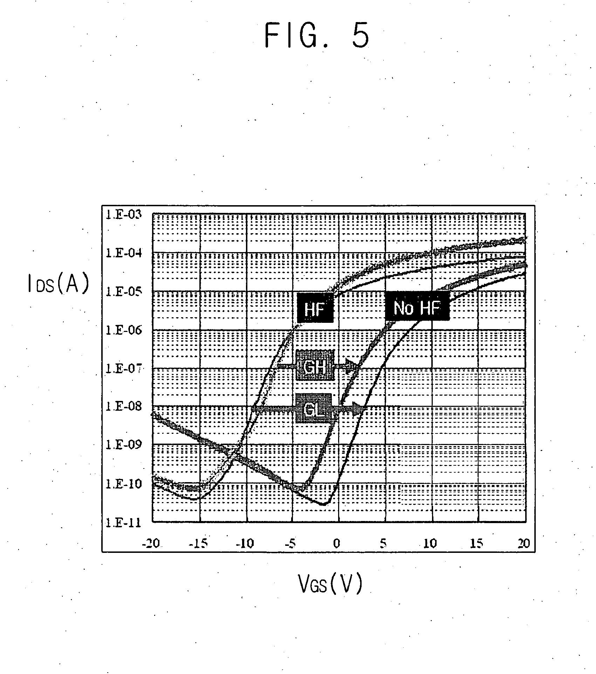

FIG. 5 illustrates the hydrofluoric acid treatment effect on I_{on/Off} characteristics in a GH case where the first insulating layer 141 is formed fast and in a GL case where the first insulating layer 141 is formed slowly. If the speed of forming the first insulating layer 141 is fast, a silicon nitride layer with low density is formed. If the speed thereof is slow, a silicon nitride layer with high density is formed.

The I_{off} value does not vary remarkably with the hydrofluoric acid treatment in the both GH and GL cases. On the other hand, an Iₒₙ value increases by the acid treatment with hydrofluoric acid in the both GH and GL cases. Thus, the characteristics of the Iₒₙ/I_{off} are improved by the hydrofluoric acid treatment regardless of the first insulating layer 141 forming conditions.

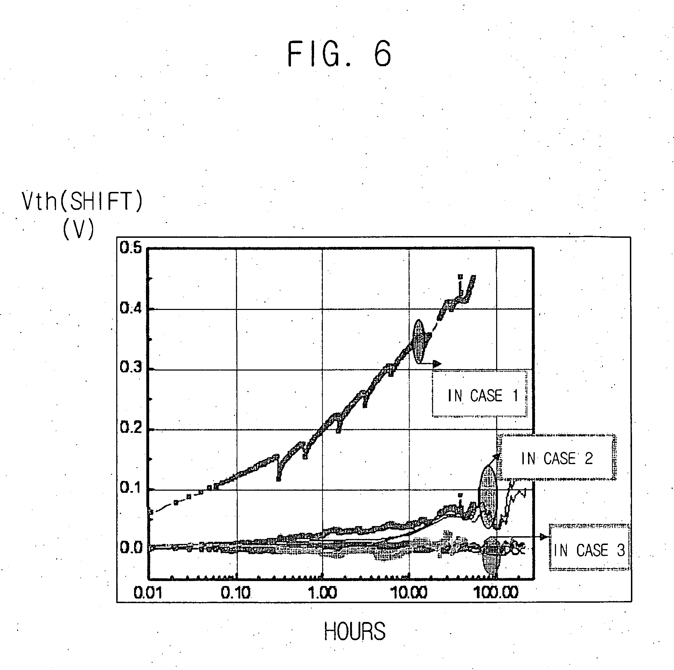

FIG. 6 illustrates variations on threshold voltage Vth shift characteristics of the TFT according to a hydrofluoric acid treatment and a hydrogen plasma treatment.

In case 1, the semiconductor layer 121, which is exposed by etching the ohmic contact layer 122, is treated with hydrogen plasma without the hydrofluoric acid treatment. In case 2, the semiconductor layer 121 is not treated with hydrofluoric acid, and is treated with hydrogen plasma before etching the ohmic contact layer 122 and while forming the first insulating layer 141. In case 3, the semiconductor layer 121 is treated with hydrofluoric acid.

The case 2 includes experiments under various degrees of hydrogen plasma treatment at different steps in the manufacturing process, and the case 3 includes experiments under various conditions of the hydrogen plasma treatment.

In case 1 and case 2 without the hydrofluoric acid treatment, the threshold voltage Vth increases proportionately to time regardless of the hydrogen plasma treatment, thereby degrading the quality of the TFT. In the case 3 with the hydrofluoric acid treatment, on the other hand, the threshold voltage Vth is constant regardless of the hydrogen plasma treatment. If the semiconductor layer 121 is treated with hydrofluoric acid, it takes over 50000 hours to increase the threshold voltage Vth by 0.2V. If the semiconductor layer 121 is not treated with hydrofluoric acid, it takes thousands of hours to increase the threshold voltage Vth by 0.2V.

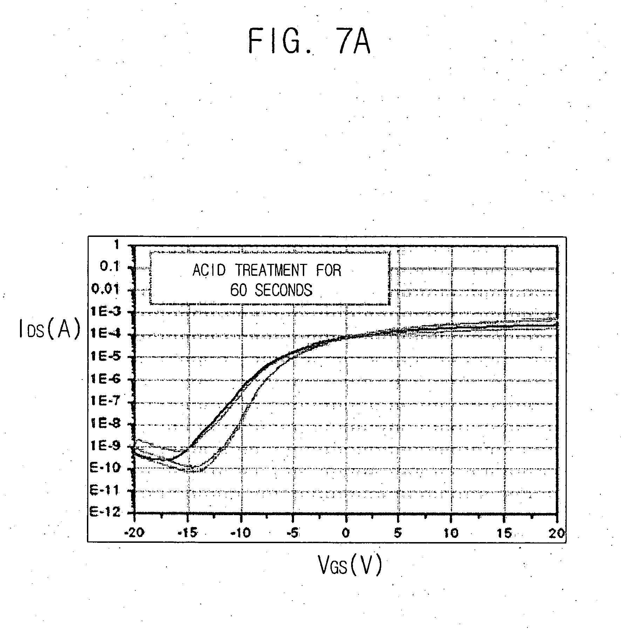

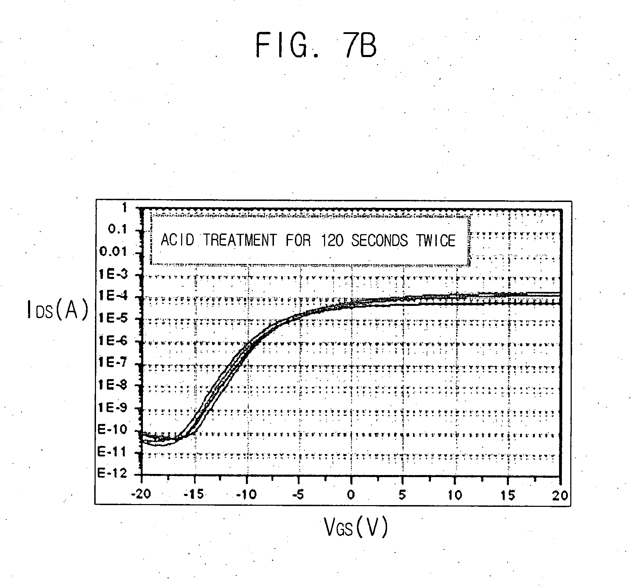

FIGs. 7A and 7B illustrate variation on characteristic of the TFT depending on degrees of the acid treatment. FIGs. 7A and 7B show variations of current amounts I_{ds} between the drain electrode and the source electrode depending on voltage differences Vgs between the gate electrode and the source electrode in TFTs under the same condition.

The semiconductor layer 121 is treated by dipping in hydrofluoric acid for 60 seconds in FIG. 7a, and for 120 seconds twice in FIG. 7B. As the dipping time increases, the characteristics of the TFTs become uniform.

As described above, the exposed semiconductor layer 121 is acid-treated, and thus the TFT T becomes uniform in quality and excellent in characteristics.

Meanwhile, the organic layer 170 in the first embodiment is formed by a wet method such as ink jetting. Alternatively, the organic layer 170 may be formed by a dry method such as vapor deposition. In this case, a hole transferring layer, an electron transferring layer, an electron injecting layer, or the like may further be formed, and may be formed throughout the insulating substrate 110 except the light emitting layer 172. The organic layer 170 is formed in order of the hole injecting layer, the hole transferring layer, the light emitting layer, the electron transferring layer and the electron injecting layer.

The hole injecting layer and the hole transferring may be formed of amine derivatives having intense fluorescence, for example, triphenyldiamine derivatives, styrylamine derivatives or amine derivatives having an aromatic fused ring.

The electron transferring layer may be made of quinoline derivatives, especially aluminum tris (8-hydroxyquinoline) (Alq3), phenyl anthracene derivatives or tetraarylethene derivatives, for example.

In another embodiment, an organic layer is formed by a dry method, and a light emitting layer emits light of white color. In a bottom-emission display device, a color filter is formed between the light emitting layer and an insulating substrate to endow the light with color. In a top-emission display device, a color filter is formed on a common electrode to endow the light with color.

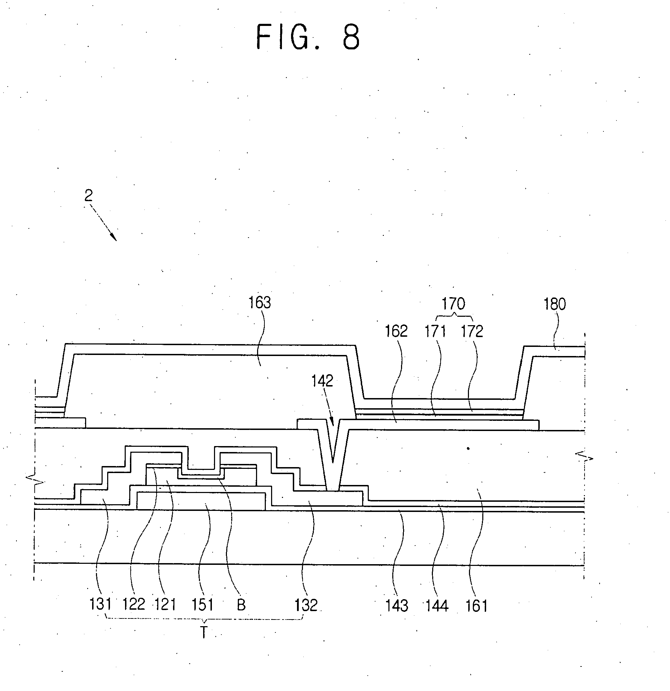

Referring to FIG. 8, a display device 2 according to a second embodiment will be described.

In the display device 2, a gate electrode 151 is disposed under a semiconductor layer 121, and a buffer layer 111 is not formed. In the display device 2, the semiconductor layer 121 including fluorine is treated with hydrofluoric acid, thereby improving characteristics of TFT. Insulating layers 143 and 144 may be made of silicon nitride.

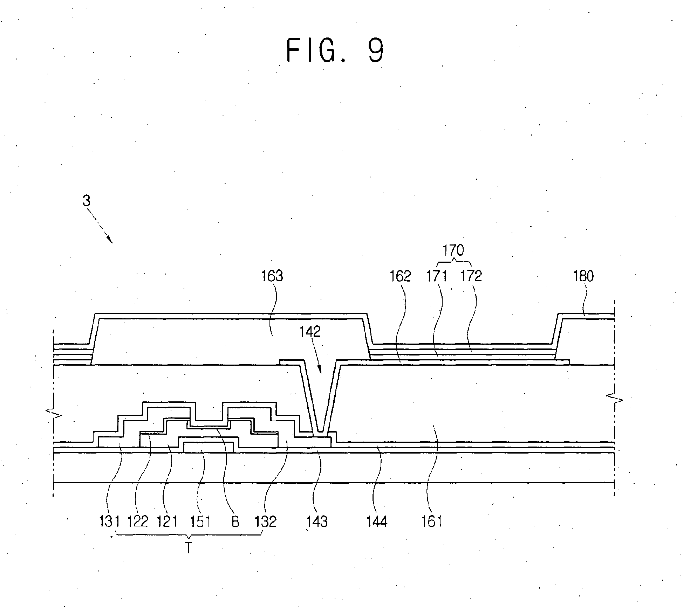

Referring to FIG. 9, a display device 3 according to a third embodiment will be described.

A semiconductor layer 121 in the display device 3 is made of amorphous silicon. However, the semiconductor layer 121 becomes to include fluorine by a treatment with hydrofluoric acid, thereby improving characteristics of TFT.

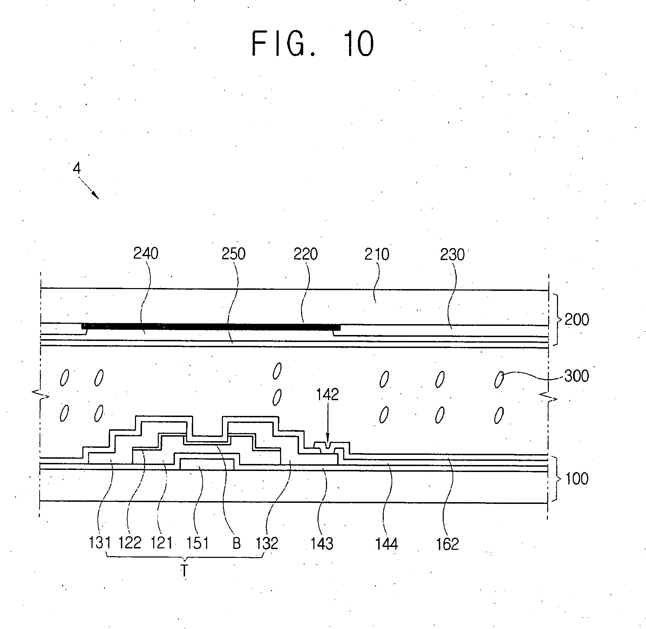

Referring to FIG. 10, a display device 4 according to a fourth embodiment will be described.

The display device 4 comprises a first substrate 100 where TFTs T are formed, a second substrate 200 opposite to the first substrate 100, and a liquid crystal layer 300 disposed between the two substrates 100 and 200.

As for the second substrate 200, a black matrix 220 is formed a matrix form on an insulating substrate 210. The black matrix 220 may be made of an organic material including a black pigment and formed to correspond to the TFTs T and wires (not shown) on the first substrate 100.

A color filter 230 is formed between the black matrixes 220. The color filter 230 is made of an organic material and includes a plurality of sub-layers with different colors. An overcoat layer 240 and a common electrode 250 of a transparent conductive material are formed on the black matrix 220 and the color filter layer 230.

The liquid crystal layer 300 is disposed between the two substrates 100 and 200, and liquid crystal molecules therein are arranged by an electric field formed by a pixel electrode and the common electrode 250.

As described above, the present invention provides a display device including TFTs having improved characteristics.

Further, the present invention provides a method of making a display device to include TFTs having improved characteristics.

It will be apparent to those skilled in the art that various modifications and variations can be made in the present invention without departing from the spirit or scope of the invention. Thus it is intended that the present invention cover the modifications and variations of this invention provided they come within the scope of the appended claims and their equivalents.

## Claims

1. A display device comprising:
an insulating substrate;
a semiconductor layer formed on the insulating substrate and comprising silicon and fluorine;
a source electrode of which at least a portion is formed on the semiconductor layer;
a drain electrode of which at least a portion is formed on the semiconductor layer and which is separated from the source electrode with a channel region disposed therebetween;
an ohmic contact layer formed between the semiconductor layer and the source electrode and between the semiconductor layer and the drain electrode; and
an insulating layer formed on the semiconductor layer.

2. The display device according to claim 1, wherein the semiconductor layer is thinner in the channel region than in the circumference thereof.

3. The display device according to claim 2, wherein the semiconductor layer comprises polysilicon.

4. The display device according to claim 3, further comprising a gate electrode disposed on the insulating layer and corresponding to the channel region.

5. The display device according to claim 4, further comprising a buffer layer disposed between the insulating substrate and the semiconductor layer and comprising silicon oxide.

6. The display device according to claim 4, wherein a contact hole is formed in the insulating layer to expose the drain electrode, and the display device further, comprises a pixel electrode which is connected to the drain electrode through the contact hole.

7. The display device according to claim 6, further comprising an organic light emitting layer formed on the pixel electrode.

8. A display device comprising:
an insulating substrate;
a semiconductor layer formed on the insulating substrate and comprising silicon;
a source electrode of which at least a portion is formed on the semiconductor layer;
a drain electrode of which at least a portion is formed on the semiconductor layer and which is separated from the source electrode with a channel region disposed therebetween;
an ohmic contact layer formed between the semiconductor layer and the source electrode, and between the semiconductor layer and the drain electrode;
an interface layer formed on the semiconductor layer in the channel region and comprising silicon and fluorine; and
an insulating layer formed on the interface layer.

9. A method of making a display device comprising:
forming a semiconductor layer and an ohmic contact layer sequentially on an insulating substrate;
forming a source electrode and a drain electrode which are separated from each other with a channel region disposed there between on the ohmic contact layer;
exposing the semiconductor layer disposed between the source, electrode and the drain electrode by removing a portion of the ohmic contact layer which is not covered with the source electrode and the drain electrode;
acid-treating the exposed semiconductor layer; and
forming an insulating layer on the semiconductor layer after the acid-treating.

10. The method according to claim 9, wherein the acid-treating is performed with at least one of hydrofluoric acid, sulphuric acid and nitric acid.

11. The method according to claim 10, wherein the acid-treating is performed with hydrofluoric acid.

12. The method according to claim 11, wherein the concentration of the hydrofluoric acid is 0.001 volume percent to 10 volume percent.

13. The method according to claim 11, wherein the acid-treating is performed with a dipping method or a spray method.

14. The method according to claim 11, further comprising treating the semiconductor layer with hydrogen plasma after the acid-treating.

15. The method according to claim 11, wherein the forming the semiconductor layer comprises forming an amorphous silicon layer on the insulating substrate; and crystallizing the amorphous silicon layer.

16. The method according to claim 15, further comprising forming a buffer layer including silicon oxide on the insulating substrate, wherein the amorphous silicon layer is formed on the buffer layer.

17. The method according to claim 15, further comprising forming a gate electrode on the insulating layer corresponding to the channel region.

18. The method according to claim 15, further comprising forming a contact hole in the insulating layer to expose the drain electrode; and forming a pixel electrode which is connected to the drain electrode through the contact hole.

19. The method according to claim 18, further comprising forming an organic light emitting layer on the pixel electrode.
